# EUROPEAN PATENT SPECIFICATION

(11) **EP 1 523 773 B1**
(45) Date of publication and mention of the grant of the patent: **22.09.2010**
(21) Application number: 03763889.7
(22) Date of filing: 16.07.2003
(51) Int. Cl.: H01L 21/762

(54) **METHOD OF SMOOTHING THE OUTLINE OF A USEFUL LAYER OF MATERIAL TRANSFERRED ONTO A SUPPORT SUBSTRATE**
VERFAHREN ZUR GLÄTTUNG DES UMRISSES EINER AUF EIN STÜTZSUBSTRAT ÜBERTRAGENEN NUTSCHICHT
PROCEDE DE LISSAGE DU CONTOUR D'UNE COUCHE DE MATERIAU UTILE TRANSFEREE SUR UN SUBSTRAT DE SUPPORT

(30) Priority: 17.07.2002 FR 0209022; 09.04.2003 US 461524 P
(43) Date of publication of application: 20.04.2005
(60) Divisional application: 09178890.1
(73) Proprietor: S.O.I.Tec Silicon on Insulator Technologies, 38190 Bernin (FR)
(72) Inventor: GHYSELEN, Bruno, F-38170 Seyssinet-Pariset (FR)
(74) Representative: Bomer, Françoise Marie
(86) International application number: PCT/EP2003/007852
(87) International publication number: WO 2004/008525

(56) References cited:
- EP-A- 1 059 663
- EP-A- 1 189 266
- US-A- 5 597 410
- US-A1- 2001 055 854
- US-B1- 6 309 950

## Description

The present invention relates to a method of smoothing the outer outline of a useful layer of a semiconductor material transferred onto a support during the fabrication of substrates for electronics, optics, or optoelectronics.

Currently, all substrates fabricated using techniques combining bonding by molecular bonding (known as "wafer bonding") and transferring a useful layer onto a support have a zone known as a "peripheral ring".

Said ring is a zone located at the periphery of the support and for which transfer of the useful layer has not occurred, or when transfer has occurred, said ring is a zone in which the useful layer has been transferred partially, or has disappeared during subsequent treatment, due to its poor bonding to said support.

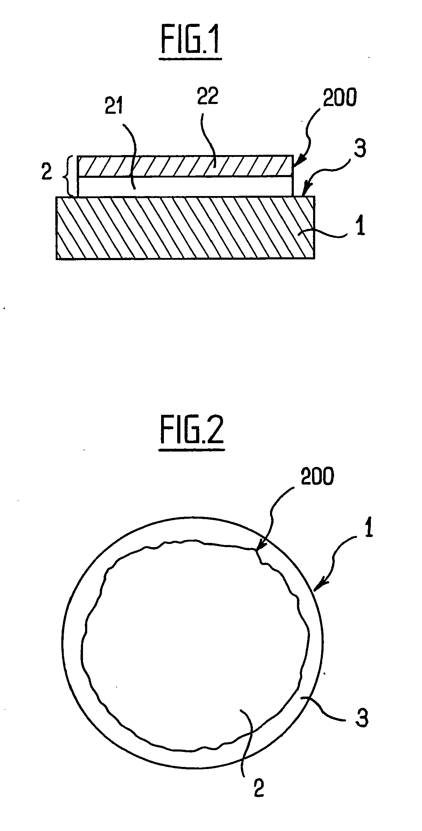

Accompanying Figures 1 and 2 are respective cross sectional and plan views of a substrate that is known to the skilled person under the acronym "SOI" meaning "silicon on insulator".

Figure 1 shows a support 1 of silicon onto which a composite layer 2 comprising a layer of silicon oxide 21 surmounted by a layer of silicon 22 has been transferred by molecular bonding.

The term "ring" 3 defines a substantially annular zone of support 1 onto which the composite layer 2 has either not been transferred or has been transferred poorly during transfer of the layer. The plan view (see Figure 2) shows that said ring 3 varies in width, i.e., the lateral vertical side 200 of the composite layer 2 is irregular or jagged.

It should be noted that Figures 1 and 2 and the remaining figures are diagrams that are not to scale both as regards the thickness of the different layers and of the support and as regards the width of the ring.

Said ring phenomenon occurs with other substrates, for example those known under the acronym "SICOI" meaning "silicon carbide on insulator" or under the acronym "SOQ" meaning "silicon on quartz". Other multi-layer substrates such as those comprising gallium arsenide on silicon (AsGa/Si) also exhibit said ring.

Independently of the diameter of support 1, which can vary, for example, from 2 inches (50 millimeters (mm)) for silicon carbide to 12 inches (300 mm) for certain silicon substrates, said ring 3 is regularly a few millimeters in width. Further, said width can vary, i.e., it can be 1 mm on one side of the substrate and can reach 4 mm on the other side, for example.

The appearance of said ring during layer transfer has a variety of origins, as discussed below. Particular mention can be made of the existence of chamfers on the substrates used, variations in bonding energy, the bonding techniques employed, and finally certain aggressive steps in substrate fabrication methods.

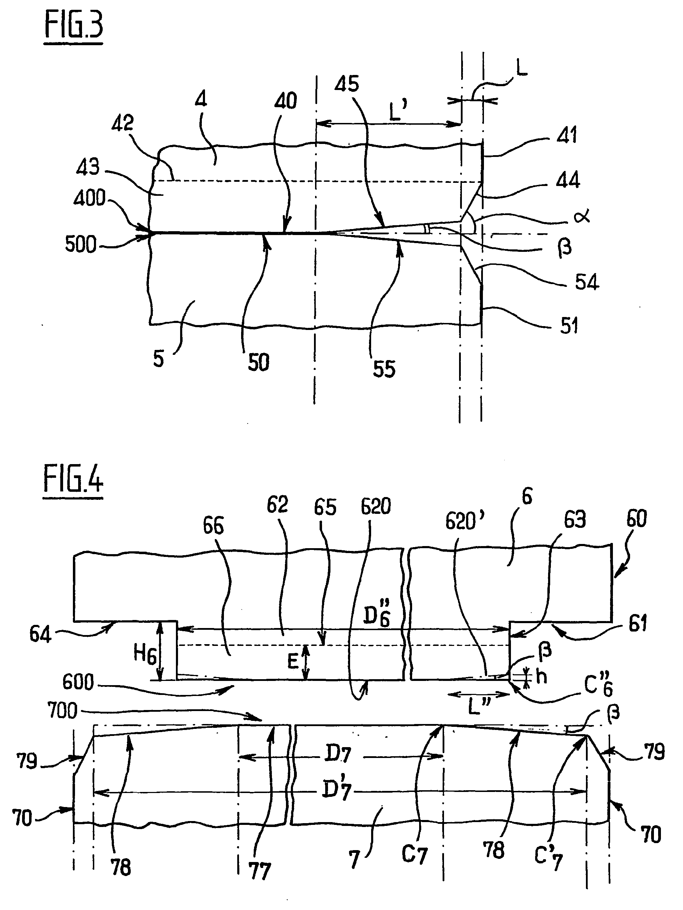

In order to explain the appearance of said ring, reference is made to the accompanying Figure 3 which is a diagrammatic cross section of a portion of the sides of two substrates bonded together by molecular bonding, namely a source substrate 4 from which the future useful layer is to be cut, and a support substrate 5 intended to receive said useful layer. This figure illustrates the prior art.

In the remainder of the description and drawings, the substrates are assumed to be circular in shape as this is the shape encountered most frequently. However, they can have other shapes.

The source substrate 4 has two opposite faces that are parallel; in Figure 3 reference numeral 400 designates a "front" one of said faces. Said front face 400 is intended for bonding onto said support 5. The source substrate 4 has a side 41 which is perpendicular to the plane of said front face 400.

Further, the substrate 4 has undergone treatment that forms a zone of weakness 42 that defines two portions, a rear portion and a useful layer 43 intended for subsequent transfer to the support 5.

Throughout the remainder of the description and claims, the expression "useful layer" designates a transferred layer of thickness that depends on whether it is obtained, for example, by a method of implanting atomic species or by abrasive polishing and/or chemical etching as is described below.

Currently, the substrates used both as the source substrate and as the support substrate are commercially available substrates satisfying standardized requirements (for example SEMI standards for a silicon substrate) mainly concerned with ensuring said substrates can be accepted by the equipment of as wide a range of users as possible.

According to those standards, at the intersection between the side 41 and the front face 400, the substrate 4 has an annular primary chamfer 44 or primary drop making a large angle α (close to 45°) with the plane of said front face 400 and more precisely with the rigorously flat central zone, as will be explained below. Said primary chamfer 44 extends over a width **L** in the radial direction. Said width **L** varies from 100 micrometers (µm) to 500 µm depending on the different substrates. Said primary chamfer 44 is intended to limit the risk of mechanical rupture and notching of the source substrate 4.

In a similar manner to that just described for the source substrate 4, the support substrate 5 has a front face 500, a side 51 and a primary chamfer 54.

When substrates 4 and 5 are bonded to each other, bonding does not occur at chamfers 44 and 54 because of the magnitude of angle α. The width of the ring can thus be expected to correspond to the width **L** of said primary chamfers 44 and 54. It has been shown, however, that it is even wider in practice.

It has been observed that the front face 400 of substrate 4 actually has two zones, namely a first rigorously flat zone 40 located substantially at the center of said substrate 4 and hereinafter termed the "flat central zone" and a second zone 45 surrounding the first zone.

The second zone 45 is a secondary annular chamfer or secondary drop forming an angle β with the plane of the central zone 40. This angle β is very small, generally less than 1°, so the secondary chamfer 45 actually constitutes a slight deviation from the plane of the central zone 40. Said secondary chamfer 45 extends between the flat zone 40 and the primary chamfer 44.

Throughout the remainder of the description and claims, the expression "flat" means a flatness that is suitable for bonding, and the expression "central zone" designates a zone located substantially at the center of the front face of the substrate but which can, however, be located slightly excentrically on said face.

It should be noted that Figure 3 and the following figures are only diagrammatic in nature and the magnitude of angle β has been considerably exaggerated in the figures for clarification purposes.

More precisely, the secondary chamfer 45 constitutes a drop that is less sharp than the primary chamfer 44 and which appears during the various substrate shaping steps (lapping, polishing, chemical etching), these steps producing an etching and material-removal effect that is greater on the substrate side. Said secondary chamfer 45 is not subject to standards. Its width **L'** taken in a radial direction varies from about 500 µm to 3000 µm. Said secondary chamfer 45 is a poorly defined zone of dimensions that are neither controlled not completely reproducible from one substrate to another. Further, the value of angle β also fluctuates, and so secondary chamfer 45 is not flat as shown diagrammatically in Figure 3 but can be domed or irregular in places.

As a result, in reality (and in contrast to the diagrammatic representation of the figures), the side of the source substrate 4 is not formed by a plurality of beveled slopes but has a somewhat rounded shape, i.e., without edges between the secondary chamfer 45 and the primary chamfer 44 or between the primary chamfer and the side 41.

In a manner similar to that just described for the source substrate 4, the support substrate 5 has a flat central zone 50 and a substantially annular secondary chamfer 55, but has the same irregularities as the secondary chamfer 45.

Molecular bonding is a technique that cannot tolerate non-planar surfaces and the existence of said secondary chamfers 45, 55 results in poor bonding and layer transfer in that zone, resulting in the appearance of a peripheral ring.

A second reason for the appearance of said ring is that in general, the bonding energy between two facing faces reduces on moving from the center to the side of a substrate with the degree of bonding varying. In other words, the bonding energy is always lower at the periphery of the substrates.

The bonding energy also fluctuates as a function of parameters such as roughness, flatness and the chemical nature of the surfaces in contact, the presence of particles, etc. Said parameters can also vary in a less controlled manner at the sides of the substrates.

Further, the bonding energy also depends on the deformation force on the source substrate and on the support substrate when they are pressed against each other. When bonding with bond initiation on one side, it is observed that the bonding energy is lower over the final portion of the bonding wave than over the initial portion or the central portion. As a result, in the final bonding zone, the ring is often more irregular and/or wider and/or more fragile.

Finally, a third possible cause for formation of the ring is the use of certain aggressive steps during the substrate fabrication methods.

Methods of fabricating substrates known under the acronym BESOI (bond and etchback silicon on insulator) bond a source substrate onto a support substrate, at least one of the faces of the source substrate being coated with a layer of oxide. The exposed surface of the source substrate then undergoes an abrasive polishing and/or chemical attack etching treatment followed by polishing until said source substrate becomes a useful layer.

In that type of method involving chemical attack (with the risk of partial delamination of the bonding interface), oxidation affecting the lateral and frontal portions of the source substrate, and mechanical abrasive polishing forces, both tend to enlarge the ring.

Similarly, in methods involving detachment of the layer by fracture along a zone of weakness, it has been observed that around the sides, detachment tends to occur at the bonding interface and not at the zone of weakness, resulting in the formation of an annular ring with a large surface area.

Referring again to Figure 3, in the particular case of the zone of weakness 42 being formed by hydrogen implantation, it has been shown that, during subsequent treatment to detach the useful layer 43 from the remainder of the source substrate 4, expansion of hydrogen bubbles exerts a substantially perpendicular force on the plane of the secondary chamfer 45. In that zone, said force is not compensated by the existence of a surface that is in direct contact with and against which said secondary chamfer can press, since the secondary chamfer 55 is spaced from the secondary chamfer 45 by an angle 2β. Thus, bubbles are formed at the surface of the secondary chamfer 45 and those bubbles further reduce the bonding force between the secondary chamfers 45 and 55.

A number of disadvantages are associated with the existence of said peripheral ring.

Firstly, the side of the transferred useful layer defining said ring is fragile and can crumble away during the treatments to which the final substrate is subjected. In addition to the disappearance of precious millimeters of useful layer during the component fabrication, crumbling of said layer produces particles that are a source of pollution that severely affects the fabrication yields of circuits formed from said components. By way of example, a particle with a diameter of the order of 0.1 µm is sufficient to destroy a 0.25 µm circuit.

Finally, said ring is irregular, as explained above, and its width can vary from about 1 mm to 4 mm from one side of the substrate to the other, which causes problems in reproducibility of the different steps in an industrial process when such a substrate is used in a production facility.

The document EP-1 059 663 describes a process for producing a semiconductor thin film comprising the steps of forming a semiconductor layer and a porous layer on a first substrate, removing said semiconductor layer at its peripheral region and separating the semiconductor layer from the first substrate by using a second substrate bonded to the surface of the semiconductor layer.

This process aims to solve a splitting problem related to the fact that the transferred layer has been epitaxially grown on the porous layer.

This document is not concerned by the smoothing of the outline of a useful layer transferred onto a support substrate nor by the bonding of two substrates comprising primary and secondary chamfers.

The document US2001/055854 describes a process for producing a semiconductor member, which includes bonding and separating steps for transferring a semiconductor layer onto a receiving substrate and also the removing of the peripheral region of said semiconductor layer prior to its transfer.

Nevertheless, this document does not mention the existence of primary and secondary chamfers and the related problems of poor bonding between the source substrate and the support substrate and does no more suggest to adapt the machining operation to take this point into account.

The document US 5,597,410 describes a method to eliminate a sharp edge problem in a bonded wafer technique, which includes bonding wafers of different dimensions and chamfers.

An aim of the invention is to overcome the disadvantages described above and in particular to render smooth and regular the side face or rim of the useful layer transferred onto a support during a layer transfer method.

To this end, the invention provides a method of smoothing the outline of a useful layer of material transferred onto a support substrate during the fabrication of a composite substrate for electronics, optics, or optoelectronics, said method comprising at least one step of molecular bonding one of the faces of a source substrate termed the "front face" to the face that faces said support substrate, termed the "receiving face", and a step of transferring a useful layer deriving from said source substrate onto said support substrate.

In accordance with the invention, prior to said bonding step, only one of the two faces selected from said front face and said receiving face undergoes a machining operation intended to form a shoulder over at least a portion of its periphery, said shoulder defining an inner projecting zone that has a top face of regular outline, the other of the two faces being bordered by a primary chamfer and having a rigorously flat central zone termed the "flat zone" and an intermediate zone termed the "secondary chamfer" located between said primary chamfer and said flat zone, the dimensions of the outline of said top face of the projecting zone being less than or equal to the dimensions of the outer outline of the secondary chamfer zone of the facing substrate, said top face being bonded to the facing substrate so that its outline is inscribed within the outer outline of said secondary chamfer zone, so that after bonding, said useful layer is transferred to said support substrate with a regular outline.

Other advantageous non-limiting characteristics of the invention, taken alone or in combination, are:
· the dimensions of the outline of said top face of the projecting zone of the substrate that has undergone machining are less than or equal to the dimensions of the outer outline of the flat zone of the facing substrate, said top face being bonded to the facing substrate, so that its outline is inscribed within the outer outline of said flat zone;
· the top face of the projecting zone of the substrate that has undergone machining is bonded to the facing substrate so that it is centered with respect to the secondary chamfer zone or to the flat zone thereof;
· the side face of the projecting zone is substantially perpendicular to the plane of the top face thereof;
· the step of machining the shoulder is carried out on the front face of the source substrate;
· prior to the bonding step, the method consists in forming a zone of weakness within said source substrate, said useful layer extending between said zone of weakness and the front face of said substrate, and after the bonding step, the method consists in detaching said useful layer from the remainder of the source substrate along said zone of weakness;
· the operation of machining the shoulder on the front face of the source substrate is carried out prior to or after the step of forming the zone of weakness;
· the height of the projecting zone of the source substrate is greater than or equal to the thickness of said useful layer;
· the height of said projecting zone of the source substrate is very substantially greater than the thickness of said useful layer, and after the step of detaching said useful layer from the remainder of the source substrate, the following cycle of operations is carried out at least once, said cycle consisting in:
   a) forming a zone of weakness within said projecting zone, the useful layer extending between said zone of weakness and the top face of the projecting zone (said step optionally being preceded by a step of finishing the top face of the projecting zone);
   b) molecular bonding said top face to the receiving face of said support substrate, so that its outline is inscribed within the outer outline of said secondary chamfer zone of said support;
   c) detaching said useful layer from the remainder of the source substrate along said zone of weakness;
· said zone of weakness is formed by implanting atomic species or is formed by a porous layer;
· the height of said projecting zone is 10 nanometers (nm) or more, preferably 200 nm or more;
· the useful layer is detached by at least one of the following techniques taken alone or in combination: applying stresses of mechanical or electrical origin; supplying thermal energy, and chemical etching;
· the support substrate is produced in a material that is optionally a semiconductor, preferably selected from silicon, a transparent substrate, silicon carbide, gallium arsenide, indium phosphide and germanium;
· the source substrate is preferably formed of a semiconductor material in particular selected from silicon, germanium, compounds of silicon and germanium, silicon carbide, gallium nitride, gallium arsenide and indium phosphide;
· at least one of the bonded-together faces of the front face of the source substrate and the receiving face of the support substrate is coated in a layer of an insulating material.

Other characteristics and advantages of the invention become apparent from the following description of a preferred implementation of the invention. This description is made with reference to the accompanying drawings in which:
- Figure 1 is a diagram showing a vertical diametrical section through an SOI type substrate;
- Figure 2 is a diagram showing a plan view of the substrate of Figure 1;
- Figure 3 is a diagram showing a fragmentary vertical section of a source substrate and a support substrate bonded together using a prior art technique;
- Figures 4, 5 and 6 are diagrams showing fragmentary vertical sections of variations of a source substrate and a support substrate ready for bonding to each other using the method of the invention; and
- Figure 7 is a diagrammatic plan view, on a different scale to the preceding figures, of a composite substrate comprising a support covered with a useful layer obtained by the method of the invention.

The aim of the invention is to improve methods of fabricating a composite substrate such as the methods described above and which include at least one step of molecular bonding one of the faces of a source substrate to a facing face of a support substrate, and a step of transferring a useful layer from said source substrate onto the support substrate.

Said composite substrates thus comprise at least one useful layer deriving from a source substrate transferred onto a support substrate.

According to the characteristics of the method of the invention, prior to the molecular bonding step, one of the faces of the source substrate or the support substrate for bonding to each other, or even both, undergoes a machining operation to form a shoulder on said face. Said shoulder defines an inner (i.e., substantially central) projecting zone with a side face and with a top face that is flat or substantially flat.

During subsequent bonding, said flat top zone of the projection bonds to a zone of the facing substrate, which zone has either also been rigorously flattened, or else is spaced by only a small angle β from said flat zone, as is described in detail below. Thus, bonding is improved.

In addition, in contrast, the annular zone surrounding the projection does not come into contact with the facing substrate at all. This results in a much clearer and cleaner boundary between the facing zones of the two substrates which are bonded together and the zones which are not bonded to each other at all.

With reference now to Figure 4, in a first implementation of the invention there is a projecting zone only on the source substrate 6 (from which a useful layer will subsequently be removed).

This generally circular source substrate 6 has a side 60.

Prior to the bonding step, the front face 600 of the source substrate 6 (i.e., the face intended to be bonded against the support substrate 7) has been machined to produce a shoulder 61 over at least a portion of its periphery and generally over all or almost all of the periphery (with the occasional exception of a zone known as a flat or notch which marks the crystallographic planes).

The shoulder 61 is advantageously produced by etching (in particular localized etching), by lapping, or by polishing localized on the side. In the case of lapping, the tool used to form the primary chamfer is adapted to the shape of the shoulder. These techniques are known to the skilled person and are not described in more detail here.

Said shoulder 61 defines an inner projecting zone 62 with a side face 63 and a top face 620. The face 620 is intended to be bonded to the face 700 of the support 7, the "receiving face".

Said face 620 is generally flat (as shown in the solid lines on Figure 4). However, when shoulder 61 has been machined from a source substrate 6 with a secondary chamfer, the face 620 may not be rigorously flat and has at its periphery a residue of the secondary chamfer, i.e., an annular zone 620' forming a very small angle β with the plane of the flat central zone 620.

However, the width **L"** of said zone 620' is small and so with angle β also being small, the height **h** corresponding to the distance at the side face 63 between the zone 620' and the plane (horizontal in the figure) of the surface 620, is also small. Thus, said surface 620 can be considered to be almost flat.

The surface of the source substrate which surrounds the projecting zone 62 is termed the "setback surface" and has reference numeral 64. The face 620 (optionally including the zone 620') is termed the "top face" in contrast to this setback surface.

Throughout the description and claims, for simplification purposes, reference is made only to the top face 620 being flat even if it includes a slightly inclined portion 620'.

Advantageously, the side face 63 is perpendicular or substantially perpendicular to the plane of the top face 620.

Preferably, but not necessarily, the source substrate 6 is in the shape of a disk, the projecting zone 62 is cylindrical, and the setback surface 64 is annular.

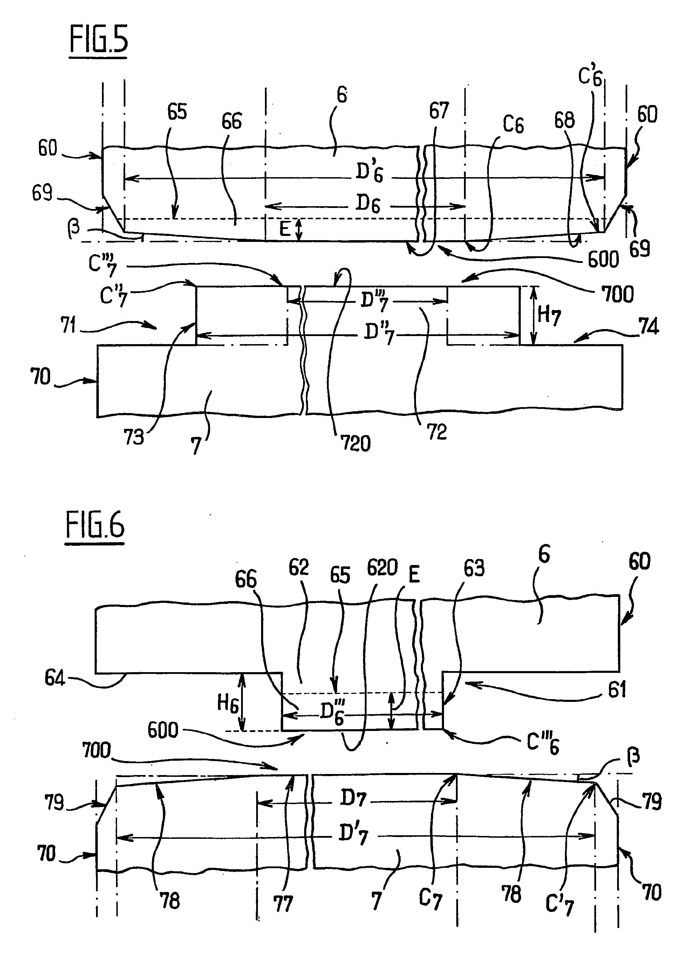

Figure 5 shows a second implementation of the invention that is the reverse of that just described, in which the front face 600 of the source substrate does not have a projecting portion while the receiving face 700 of the support substrate 7 has a projecting portion. However, it should be noted that the useful layer 66 will always be removed subsequently from the source substrate 6.

In this case, and in a manner similar to that described above for the source substrate 6, the support substrate 7 has a side 70, a shoulder 71, and a setback surface 74, an inner projecting zone 72 with a side face 73 and a flat or substantially flat top face 720. The procedures for obtaining these different portions and their geometrical characteristics are identical to those described above for the source substrate 6.

It would also be possible to machine a projecting zone on the front face 600 of the source substrate 6 and simultaneously on the receiving face 700 of the support substrate 7.

It should be noted, however, that for reasons primarily concerned with the fact that the composite substrate obtained after the fabricating method (i.e., after detaching the useful layer 66), should advantageously no longer have a shoulder, the projecting zone is preferably machined on the source substrate 6.

The height of the projecting zone 62 of the source substrate 6 bears numerical reference **H₆** while the height of the projecting zone 72 of the source substrate 7 bears reference **H₇.**

Advantageously, said heights **H₆** or **H₇** are at least 10 nm, so as to produce a clear boundary between the top flat face 620 which will be bonded to the support substrate 7 and the setback surface 64 which will not bond (respectively between the top flat surface 720 which will be bonded to the source substrate 6 and the setback surface 74, which will not adhere).

In practice, during industrial fabrication, these heights **H₆** and **H₇** will generally be at least 200 nm.

The lateral dimensions of the projecting zones 62 and 72 can also vary, as is described below.

The useful layer can be removed from the source substrate 6 in a variety of manners which are now described.

In a first variation, prior to the step of molecular bonding substrates 6 and 7 to each other, a zone of weakness 65 is formed within the source substrate 6 to define and delimit the useful layer 66 subsequently transferred to the support 7. After bonding, said useful layer 66 is detached from the remainder of the source substrate 6 along this zone of weakness 65.

In Figures 4, 5 and 6, to improve clarity, the thickness of the useful layer 66 is greatly exaggerated. These figures serve only as diagrams on which substrates 6 and 7 and their geometrical outlines are not shown to scale.

Techniques for forming said zone of weakness 65 are known to the skilled person and are not all described in detail.

Advantageously, this zone of weakness 65 is formed by implanting atomic species from the front face 600.

The term "implanting atomic species" means any bombardment of atomic, molecular or ionic species, which can introduce said species into a material with a maximum concentration of said species located at a predetermined depth from the bombarded surface 600. The molecular or ionic atomic species are introduced into the material with an energy that is also distributed about a maximum.

Atomic species can be implanted into said source substrate 6 using an ion beam implanter or a plasma immersion implanter, for example.

Preferably, implantation is carried out by ionic bombardment. Preferably, the implanted ionic species is hydrogen. Other ionic species can advantageously be used alone or in combination with hydrogen, such as rare gases (for example helium).

Implantation creates the zone of weakness 65 within the bulk of the source substrate 6 and at a mean ion penetration depth, the zone being substantially parallel to the plane of the front face 600. The useful layer 66 extends from the front face 600 to this zone of weakness 65.

Reference should be made, for example to the literature concerning the method known by its registered trade mark "Smart Cut".

The zone of weakness 65 can also be constituted by a porous layer obtained, for example, using the method known by its registered trade mark "ELTRAN" from Canon, described in European patent EP-A-0 849 788.

In the case shown in Figures 4 and 5 in which the projecting zone 62 is formed on the source substrate 6, it should be noted that the operation of machining the shoulder 61 can be carried out before or after the step of forming the zone of weakness 65.

This choice can be made by the manufacturer. In practice, in a production facility, the machining operation generates dust and thus will advantageously be grouped with operations of the same nature, for example formation of the primary chamfer. In this case, the zone of weakness 65 will be formed after machining. In the case in which the zone of weakness is formed on a surface with a shoulder 61, the setback surface 64 will also have a zone of weakness.

In contrast, if the zone of weakness 65 is formed before machining the shoulder, i.e., on a substantially flat surface (ignoring the secondary chamfer zone) and the shoulder is machined afterwards (and provided that, as illustrated in Figure 4, the height **H₆** of the projecting portion 62 is greater than the thickness **E** of the useful layer 66), a zone of weakness 65 is obtained solely on the projecting portion 62, which may be advantageous. In effect, a weakened peripheral zone that may generate particles is then removed.

After the bonding step, the useful layer 66 is detached from the remainder of the source substrate 6 by at least one of the following techniques used alone or in combination: application of stresses of mechanical or electrical origin, supplying thermal energy, and chemical etching. These detachment techniques are well known to the skilled person and are not described here in any more detail. A composite substrate comprising a useful layer 66 transferred onto a support 7 is produced.

More precisely, the useful layer is detached along the zone of weakness 65. In the case illustrated in Figures 4 or 6, the shoulder 61 is produced on the source substrate 6 if the height **H₆** of the projecting zone 62 is greater or equal to the thickness **E** of the useful layer 66, and the useful layer 66 is only detached along the zone of weakness 65. If, on the other hand, **E** is greater than **H₆,** then the useful layer 66 is detached both along the zone of weakness 65 and vertically upwardly in the extension of the side face 63.

When shoulder 71 is formed in support substrate 7, the useful layer 66 is detached along the zone of weakness 65 and vertically in the extension of the side face 73 of the projecting portion 72.

In the two above cases, we speak of "vertical self-definition" of the useful layer 66.

Finally, in a third variation of the implementation not shown in figures, it is also possible to produce the useful layer 66 by the technique known as "bond and etchback" in which, after bonding the front face 600 of the source substrate 6 onto the receiving face 700 of the support substrate 7, the rear face of said source substrate 6 undergoes treatment by lapping and/or etching by chemical attack, and then polishing, until only the thickness corresponding to said useful layer 66 remains on the support 7.

In the particular case of SOI (silicon on insulator) substrates, it is possible to obtain the useful layer 66 by the BESOI method mentioned above.

Certain preferred variations of implementations are described below with regard to the dimensions and shape of the projecting zone.

Referring to Figure 4, and as described above for the prior art shown in Figure 3, it can be seen that the receiving face 700 of the support substrate 7 has a rigorously flat central zone 77 and a secondary chamfer 78. Further, the support substrate 7 has a primary chamfer 79.

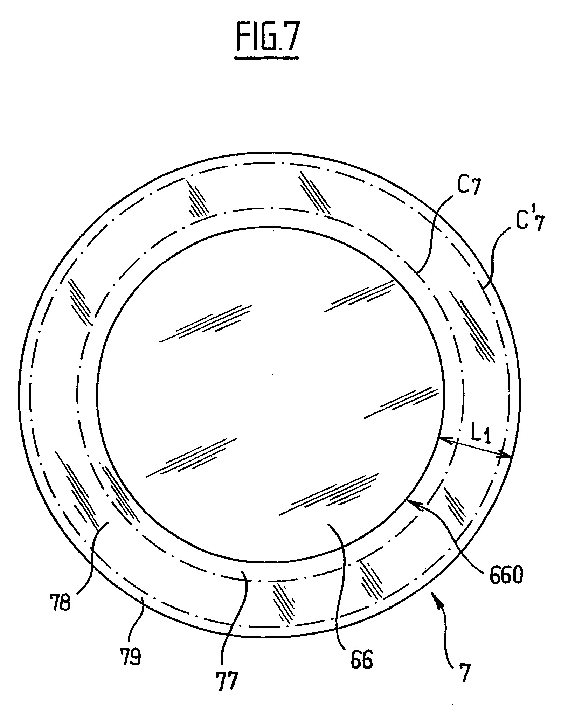

As can be seen more easily in Figure 7, and as is most often the case, the support substrate 7 is circular. This figure diagrammatically shows the flat central zone 77 that is also circular and the primary chamfer 79 and secondary chamfer 78, which are substantially annular. However, as explained above, the secondary chamfer 78 is irregular and its width can vary. Finally, the support 7 and/or the flat central zone 77 could also be oval, octagonal or rectangular in shape, for example, and the primary chamfer 79 and secondary chamfer 78 will have correspondingly different shapes.

Throughout the remainder of the description, for the purposes of simplification and as shown in the figures, the primary and secondary chamfers are assumed to be annular. '

As can be seen in Figures 4 and 7, the secondary chamfer 78 has an inner outline **C₇** and an outer outline C'₇. It should be noted that the inner outline C₇ of the secondary chamfer 78 also constitutes the outer outline of the flat central zone 77.

In the variation shown in Figure 5 (and in a manner similar to that just described for Figure 4), when the front face 600 of the source substrate 6 has no shoulder, it has a flat central zone 67, a secondary chamfer 68 and a primary chamfer 69. Further, the secondary chamfer 68 has an inner outline **C₆** and an outer outline **C'₆.**

The remarks made above regarding the support substrate 7 with no projection (see Figure 4) are applicable to the source substrate 6 with no projection of Figure 5.

The lateral dimensions of the projecting portion 62 of the source substrate 6 can vary as is described below with reference to Figures 4 and 6.

In a first variation shown in Figure 4, the dimensions of the outer outline **C"₆** of the top face 620 are less than or equal to the dimensions of the outer outline **C'₇** of the secondary chamfer zone 78 of the support substrate 7. The area of the top face 620 is thus less than or equal to the area of the receiving face 700.

When the top face 620 and the receiving face 700 are circular, the diameter **D"₆** of the top face 620 is less than or equal to the diameter **D'₇** of the receiving face 700, which includes the central face 77 and the secondary chamfer 78.

Finally, the source substrate 6 is bonded to the support substrate 7 so that said outline **C"₆** is inscribed within the outer outline **C'₇** of said secondary chamfer zone 78.

Thus, the top face 620 of the projecting portion 62 is bonded to the central flat plane 77 and optionally to the secondary chamfer zone 78 forming an angle β with the plane of said face 620. This results in better quality bonding than in the prior art illustrated in Figure 3 and with a fairly strong bonding energy.

In a second variation of the invention illustrated in Figure 6, the dimensions of the outer outline **C"'₆** of the top face 620 are less than or equal to the dimensions of the outer outline **C₇** of the flat zone 77 of the support 7. The area of the top face 620 is thus less than or equal to the area of the flat zone 77.

When the top face 620 and the central zone 77 are circular, diameter **D"'₆** of the top face 620 is less than or equal to the diameter **D₇** of said flat zone 77.

Substrate 6 is bonded to the support 7 so that said outline **C"'₆** is inscribed within the outer outline C₇ of said flat zone 77.

This allows bonding between two rigorously flat surfaces, namely the top face 620 and the flat central zone 77 of the support 7. Bonding is further reinforced compared with the variation just described. In practice, since the width of the secondary chamfer 78 varies, the dimensions of the shoulder 61 will be calculated so that its width is genuinely greater than that of the secondary chamfer 78.

Finally, and advantageously, the source substrate 6 is bonded to the support substrate 7, so that the projecting zone 62 is centered with respect to thereto. Depending on the dimensions of this projecting zone 62, this will be centered with respect to the flat central zone 77 when said zone is small (see Figure 6), or with respect to the secondary chamfer zone 78 when its dimensions are greater (see Figure 5). In practice, the substrates 6 and 7 often have the same dimensions and their sides 60, 70 will be alignment.

In a similar manner, which is therefore not described in detail, the lateral dimensions of the projecting portion 72 of the support substrate 7 can vary.

Referring now to Figure 5, it can be seen that the dimensions of the outer outline **C"₇** (or diameter **D"₇**) can be less than or equal to the dimensions of the outer outline **C'₆** (or diameter **D'₆**) of the secondary chamfer zone 68 of the source substrate 6, or even (as shown in dotted lines and dot-dash lines on support 7), less than or equal to the dimensions of the outer outline **C₆** (or diameter **D₆**) of the flat zone 67. In this case, the outline of the projecting portion 72 carries the reference **C"'₇** (diameter **D"'₇**) .

Similarly, the support 7 can be bonded against the source substrate 6 so that its projecting portion 72 is centered with respect thereto.

Regardless of the variation of the method employed, i.e., whether the shoulder is formed in the source substrate 6 or in the support substrate 7 or in both, the presence of said shoulder defines a cleaner transition between a strong bonding zone as produced between two flat or substantially flat surfaces, and a zone where bonding is absent since at least one of the two substrates 6 or 7 has a setback surface 64 or 74.

Further, outlines **C"₆** or **C"'₆** of the top surface 620 or the projecting portion 62 (respectively outlines **C"₇** or **C"'₇** of the top surface 720 of the projecting portion 72) are regular and thus the useful layer 66 transferred onto the support 7 has a regular outline 660 (see Figure 7). The ring width is **L₁.**

Advantageously, and in the case shown in Figures 4 and 6 where shoulder 61 is formed in the source substrate 6, the height **H₆** of the projecting zone 62 is greater than or equal to the thickness **E** of the useful layer 66. By way of example, this thickness **E** can be from 100 angstroms (Å) to a few micrometers.

During detachment, the transferred useful layer 66 has the dimensions and outline shape **C"₆** of said projecting zone 62.

In a further advantageous variation of the invention, when the useful layer 66 is defined by the existence of a zone of weakness 65, it is possible to begin by machining once only, a shoulder 61 of a height **H₆** that is sufficiently large, i.e., very substantially greater than **E,** and then to be able to carry out at least one cycle of operations consisting in:
- forming a zone of weakness 65 within said projecting zone 62;
- molecular bonding the top face 620 onto the receiving face 700 of said support substrate 7 as described above; then
- detaching said useful layer 66 from the remainder of the source substrate 7 along the zone of weakness 65.

This operation can be repeated so long as height **H₆** allows a useful layer 66 of the selected thickness **E** to be transferred. By way of example, in this case, the value of **H** is at least 2000 nm, or even several tens of micrometers.

Advantageously, a finishing step can be carried out on the top face 620 of the projecting zone 62 before forming the zone of weakness 65 once again.

However, clearly there is no impediment to forming the shoulder 61 and the zone of weakness 65 at each step of transferring a useful layer 66.

Finally, examples of materials to which said method can be applied are given.

The support substrate 7 is formed from a material that is optionally a semiconductor and that is selected, for example, from: silicon; a transparent substrate (such as quartz or glass, for example); silicon carbide; gallium arsenide; indium phosphide; or germanium.

Preferably, the source substrate 6 is formed from a semiconductor material selected, for example, from: silicon; germanium; silicon carbide; silicon and germanium alloys or "compounds" (known as "Si-Ge compounds"); alloys or compounds known as "III/V compounds", i.e., compounds one element of which is from column IIIa of the periodic table and the other is from column Va, such as gallium nitride; gallium arsenide; or indium phosphide.

Finally, it should be noted that it is possible to cover the receiving face 700 of the support 7 with an insulating layer of the oxide type (for example SiO₂) or of the nitride type (for example Si₃N₄) , this insulating layer then being interposed between the useful layer 66 and said support 7, after detaching said layer 66.

It is possible to cover the front face 600 of the source substrate 6 with an insulating material of the type mentioned above, the transferred useful layer 66 then comprising two layers.

In this case, the insulating material is deposited before or after forming the projecting zone 62.

It is also possible to deposit a plurality of layers onto the source substrate 6 and the term "useful layer" then designates a stack of layers.

## Claims

1. A method of smoothing the outline (660) of a useful layer (66) of material transferred onto a support substrate (7) during the fabrication of a composite substrate for electronics, optics, or optoelectronics, said method comprising at least one step of molecular bonding one of the faces (600) of a source substrate (6) termed the "front face" to the face (700) that faces said support substrate (7), termed the "receiving face", and a step of transferring a useful layer (66) deriving from said source substrate (6) onto said support substrate (7), wherein prior to said bonding step, only one of the two faces selected from said front face (600)and said receiving face (700) undergoes a machining operation intended to form a shoulder (61, 71) over at least a portion of its periphery, said shoulder (61, 71) defining an inner projecting zone (62, 72) that has a top face (620, 720) of regular outline **(C"₆, C"'₆, C"₇, C"'₇)**, the method being **characterized by** the other of the two faces (700, 600) being bordered by a primary chamfer (79, 69) and having a rigorously flat central zone (77, 67) termed the "flat zone" and an intermediate zone (78, 68) termed the "secondary chamfer" located between said primary chamfer (79, 69) and said flat zone (77, 67), the dimensions of the outline **(C"₆, C"'₆, C"₇, C"'₇)** of said top face (620, 720) of the projecting zone (62, 72) being less than or equal to the dimensions of the outer outline **(C'₇, C'₆)** of the secondary chamfer zone (78, 68) of the facing substrate (7, 6), said top face (620, 720) being bonded to the facing substrate (7, 6) so that its outline **(C"₆, C"'₆, C"₇, C"'₇)** is inscribed within the outer outline **(C'₇, C'₆)** of said secondary chamfer zone (78, 68), so that after bonding, said useful layer (66) is transferred to said support substrate (7) with a regular outline (660).

2. A method according to claim 1, **characterized in that** the dimensions of the outline **(C"'₆, C"'₇)** of said top face (620, 720) of the projecting zone (62, 72) of the substrate (6, 7) that has undergone machining are less than or equal to the dimensions of the outer outline (cm, C₆) of the flat zone (77, 67) of the facing substrate (7, 6), said top face (620, 720) being bonded to the facing substrate (7, 6), so that its outline **(C"'₆, C"'₇)** is inscribed within the outer outline **(C₇, C₆)** of said flat zone (77, 67) .

3. A method according to claim 1 or claim 2, **characterized in that** the top face (620, 720) of the projecting zone (62, 72) of the substrate (6, 7) that has undergone machining is bonded to the facing substrate (7, 6) so that it is centered with respect to the secondary chamfer zone (78, 68) or to the flat zone (77, 67) thereof.

4. A method according to any one of the preceding claims, **characterized in that** the step of machining the shoulder (61) is carried out on the front face (600) of the source substrate (6).

5. A method according any one of the preceding claims, **characterized in that** the side face (63, 73) of the projecting zone (62, 72) is substantially perpendicular to the plane of the top face (620, 720) thereof.

6. A method according to any one of the preceding claims, **characterized in that**, prior to the bonding step, the method consists in forming a zone of weakness (65) within said source substrate (6), said useful layer (66) extending between said zone of weakness (65) and the front face (600) of said substrate (6), and after the bonding step, the method consists in detaching said useful layer (66) from the remainder of the source substrate (6) along said zone of weakness (65).

7. A method according to claim 6 when it is dependant from claim 4, **characterized in that** the operation of machining the shoulder (61) on the front face (600) of the source substrate (6) is carried out prior to the step of forming the zone of weakness (65).

8. A method according to claim 6 when it is dependant from claim 4, **characterized in that** the operation of machining the shoulder (61) on the front face (600) of the source substrate (6) is carried out after the step of forming the zone of weakness (65).

9. A method according to claim 6 when it is dependant from claim 4, **characterized in that** the height **(H₆)** of the projecting zone (62) of the source substrate is greater than or equal to the thickness **(E)** of said useful layer (66).

10. A method according to claim 6 when it is dependant from claim 4, **characterized in that** the height **(H₆)** of said projecting zone (62) of the source substrate (6) is very substantially greater than the thickness **(E)** of said useful layer (66), and **in that** after the step of detaching said useful layer (66) from the remainder of the source substrate (6), the following cycle of operations is carried out at least once, said cycle consisting in:
a) forming a zone of weakness (65) within said projecting zone (62) of the source substrate (6), the useful layer (66) extending between said zone of weakness (65) and the top face (620) of the projecting zone (62);
b) molecular bonding said top face (620) to the receiving face (700) of said support substrate (7), so that its outline **(C"₆, C"'₆)** is inscribed within the outer outline **(C'₇)** of said secondary chamfer zone (78) of said support (7);
c) detaching said useful layer (66) from the remainder of the source substrate (6) along said zone of weakness (65).

11. A method according to claim 10, **characterized in that** prior to step a), a finishing step is carried out on the top face (620) of the projecting zone (62).

12. A method according to any one of claims 6 to 11, **characterized in that** said zone of weakness (65) is formed by atomic species implantation.

13. A method according to any one of claims 6 to 11, **characterized in that** said zone of weakness (65) is formed by a porous layer.

14. A method according to any one of the preceding claims, **characterized in that** the height **(H₆, H₇)** of said projecting zone (62, 72) is 10 nm or more, preferably 200 nm or more.

15. A method according to any one of claims 6 to 14, **characterized in that** the useful layer (66) is detached by at least one of the following techniques taken alone or in combination: applying stresses of mechanical or electrical origin; supplying thermal energy; and chemical etching.

16. A method according to any one of the preceding claims, **characterized in that** the support substrate (7) is produced from a material that is optionally a semiconductor, preferably selected from: silicon; a transparent substrate; silicon carbide; gallium arsenide; indium phosphide and germanium.

17. A method according to any one of the preceding claims, **characterized in that** the source substrate (6) is formed from a semiconductor material.

18. A method according to claim 17, **characterized in that** the material of the source substrate (6) is selected from: silicon; germanium; compounds of silicon and germanium; silicon carbide; gallium nitride; gallium arsenide and indium phosphide.

19. A method according to any one of the preceding claims, **characterized in that** at least one of the bonded-together faces selected from the front face (600) of the source substrate (6) and the receiving face (700) of the support substrate (7) is coated in a layer of an insulating material.

## Patentansprüche

1. Verfahren zum Glätten des Umrisses (660) einer Nutzschicht (66) von Material, die auf ein Trägersubstrat (7) übertragen wird während der Herstellung eines Verbundsubstrats für Elektronik, Optik, oder Optoelektronik, wobei das Verfahren wenigstens einen Schritt eines molekularen Bondens einer der Flächen (800) eines Ursprungssubstrats (6), genannt die "Vorderfläche", an die Fläche (700), die dem Trägersubstrat (7) gegenüberliegt, genannt die "Aufnahmefläche", umfasst sowie einen Schritt des Übertragens einer Nutzschicht (66) von dem Ursprungssubstrat (6) auf das Trägersubstrat (7), wobei vor dem Bondingschritt nur eine der beiden Flächen, ausgewählt aus der Vorderfläche (600) und der Aufnahmefläche (700), einer maschinellen Bearbeitung unterzogen wird, die dazu gedacht ist, einen Absatz (61, 71) über wenigstens einen Teils ihres Rands zu bilden, wobei der Absatz (B1, 71) einen Inneren hervorstehenden Bereich (62, 72) festlegt, der eine obere Fläche (620, 720) eines regelmäßigen Umrisses (C"₆, C"'₆, C"₇, C"'₇) aufweist, wobei das Verfahren **dadurch gekennzeichnet ist, dass** die andere der beiden Flächen (700, 600) von einer primären Schräge (79, 69) umrandet ist und einen ganz flachen Mittelbereich (77, 67) aufweist, der "flacher Bereich" genannt wird, und einen Zwischenbereich (78, 68), der "sekundäre Schräge" genannt wird, der zwischen der primären Schräge (79, 69) und dem flachen Bereich (77, 67) liegt, wobei die Abmessungen des Umrisses (C"₆, C"'₆, C"₇, C"'₇) der oberen Fläche (620, 720) des vorstehenden Bereichs (62, 72) kleiner oder gleich den Abmessungen des äußeren Umrisses (C'₇, C'₆) des sekundären Schrägberelchs (78, 68) des gegenüberliegenden Substrats (7, 6) sind, wobei die obere Fläche (620, 720) an das gegenüberliegende Substrat (7, 6) gebondet wird, so dass ihr Umriss (C"₆, C'"₆, C"₇, C"'₇) in den äußeren Umriss (C'₇, C'₆) des sekundären Schrägbereichs (78, 68) einbeschrieben ist, so dass nach einem Bonden die Nutzschicht (66) auf die Trägerschicht (7) mit einem regelmäßige Umriss (660) übertragen wird.

2. Verfahren gemäß Anspruch 1, **dadurch gekennzeichnet, dass** die Abmessungen des Umrisses (C"'₆, C'"₇) der oberen Fläche (620, 720) des vorstehenden Bereichs (62, 72) des Substrats (6, 7), die einer maschinellen Bearbeitung unterzogen wurde, kleiner oder gleich den Abmessungen des äußeren Umrisses (C₇, C₆) des flachen Bereichs (77, 67) des gegenüberliegenden Substrats (7, 6) sind, wobei die obere Fläche (620, 720) an das gegenüberliegende Substrat (7, 6) gebondet wird, so dass ihr Umriss (C"'₆, C"'₇) in den äußeren Umriss (C₇, C₆) des flachen Bereichs (77, 67) einbeschrieben ist.

3. Verfahren gemäß Anspruch 1 oder Anspruch 2, **dadurch gekennzeichnet, dass** die obere Fläche (620, 720) des vorstehenden Bereichs (62, 72) des Substrats (6, 7), die einer maschinellen Bearbeitung unterzogen wurde, an das gegenüberliegende Substrat (7, 6) gebondet wird, so dass sie in Bezug auf seinen sekundären Schrägbereich (78, 68) oder seinen flachen Bereich (77, 67) zentriert wird.

4. Verfahren gemäß einem der vorhergehenden Ansprüche, **dadurch gekennzeichnet, dass** der Schritt des maschinellen Bearbeitens des Absatzes (61) auf der Vorderfläche (600) des Ursprungssubstrats ausgeführt wird.

5. Verfahren gemäß einem der vorhergehenden Ansprüche, **dadurch gekennzeichnet, dass** die Seitenfläche (63, 73) des vorstehenden Bereichs (62, 72) im Wesentlichen senkrecht zur Ebene seiner oberen Fläche (620, 720) ist.

6. Verfahren gemäß einem der vorhergehenden Ansprüche, **dadurch gekennzeichnet, dass** vor dem Bondingschritt das Verfahren daraus besteht, einen Schwächebereich (65) innerhalb des Ursprungssubstrats (6) zu bilden, wobei sich die Nutzschicht (66) zwischen dem Schwächebereich (65) und der Vorderfläche (600) des Substrats (6) erstreckt, und nach dem Bondingschritt das Verfahren darin besteht, die Nutzschicht (66) von dem Rest des Ursprungssubstrats (6) entlang des Schwächebereichs (65) abzulösen.

7. Verfahren gemäß Anspruch 6, wenn es abhängig von Anspruch 4 ist, **dadurch gekennzeichnet, dass** das Durchführen des maschinellen Bearbeitens des Absatzes (61) auf der Vorderfläche (600) des Ursprungssubstrats (6) vor dem Schritt des Bildens des Schwächebereichs (65) ausgeführt wird.

8. Verfahren gemäß Anspruch 6, wenn es abhängig von Anspruch 4 ist, **dadurch gekennzeichnet, dass** das Durchführen des maschinellen Bearbeltens des Absatzes (61) auf der Vorderfläche (600) des Ursprungssubstrats (6) nach dem Schritt des Bildens des Schwachebereichs (65) ausgeführt wird.

9. Verfahren gemäß Anspruch 6, wenn er abhängig von Anspruch 4 ist, **dadurch gekennzeichnet, dass** die Höhe (H₆) des vorstehenden Bereichs (62) des Ursprungssubstrats größer oder gleich der Dicke (E) der Nutzschicht (66) ist.

10. Verfahren gemäß Anspruch 6, wenn er abhängig von Anspruch 4 ist, **dadurch gekennzeichnet, dass** die Höhe (H₆) des vorstehenden Bereichs (62) des Ursprungssubstrats (6) sehr wesentlich größer als die Dicke (E) der Nutzschicht (66) ist, und dass nach dem Schritt des Ablösens der Nutzschicht (66) vom Rest des Ursprungssubstrats (6) der folgende Betriebszyklus wenigstens einmal durchgeführt wird, wobei der Zyklus darin besteht:
a) Bilden eines Sohwächebereichs (65) in dem vorstehenden Bereich (62) des Ursprungssubstrats (6), wobei die Nutzschicht (66) sich zwischen dem Schwächebereich (65) und der oberen Fläche (620) des vorstehenden Bereichs (62) erstreckt;
b) Molekulares Bonden der oberen Fläche (620) an die Aufnahmefläche (700) des Trägersubstrats (7), so dass ihr Umriss (C"₆, C"'₆) in dem äußeren Umriss (C'7) des sekundären Schrägbereichs (78) des Trägers (7) einbeschrieben ist;
c) Ablösen der Nutzschicht (66) vom Rest des Ursprungssubstrats (6) entlang des Schwächebereichs (65).

11. Verfahren gemäß Anspruch 10, **dadurch gekennzeichnet, dass** vor Schritt a) ein Polierschritt auf der oberen Fläche (620) des vorstehenden Bereichs (62) ausgeführt wird.

12. Verfahren gemäß einem der Ansprüche 6 bis 11, **dadurch gekennzeichnet, dass** der Schwächebereich (65) durch Implantierung von Atomspezies gebildet wird.

13. Verfahren gemäß einem der Ansprüche 6 bis 11, **dadurch gekennzeichnet, dass** der Schwächebereich (65) durch eine poröse Schicht gebildet wird.

14. Verfahren gemäß einem der vorhergehenden Ansprüche, **dadurch gekennzeichnet, dass** die Höhe (H₆, H₇) des vorstehenden Bereichs (62, 72) 10 nm oder mehr ist, vorzugsweise 200 nm oder mehr.

15. Verfahren gemäß einem der Ansprüche 6 bis 14, **dadurch gekennzeichnet, dass** die Nutzschicht (66) durch wenigstens eine der folgenden Techniken allein genommen oder in Kombination abgelöst wird: Anlegen von Belastung mechanischen oder elektrischen Ursprungs; Zuführen thermischer Energie; und chemisches Ätzen.

16. Verfahren gemäß einem der vorhergehenden Ansprüche, **dadurch gekennzeichnet, dass** das Trägersubstrat (7) aus einem Material hergestellt wird, das optional ein Halbleiter ist, vorzugsweise ausgewählt aus: Silizium; ein transparentes Substrat; Siliziumkarbid; Galliumarsenid; Indiumphosphid und Germanium.

17. Verfahren gemäß einem der vorhergehenden Ansprüche, **dadurch gekennzeichnet, dass** das Ursprungssubstrat (6) aus einem Halbleitermaterial gebildet ist.

18. Verfahren gemäß Anspruch 17, **dadurch gekennzeichnet, dass** das Material des Ursprungssubstrats (6) ausgewählt ist aus: Silizium; Germanium; Verbindungen aus Silizium und Germanium; Siliziumkarbid; Galliumnitrid; Galliumarsenid und Indiumphosphid,

19. Verfahren gemäß einem der vorhergehenden Ansprüche, **dadurch gekennzeichnet, dass** wenigstens eine der zusammengebondeten Flächen, ausgewählt aus der Vorderfläche (600) des Ursprungssubstrats (6) und der aufnehmenden Fläche (700) des Trägersubstrats (7), mit einer Schicht eines Isoliermaterials beschichtet wird.

## Revendications

1. Procédé permettant de lisser le contour (660) d'une couche utile (66) de matériau, reportée sur un substrat support (7), lors de la fabrication d'un substrat composite pour l'électronique, l'optique ou l'optoélectronique, ce procédé comprenant au moins une étape de collage par adhésion moléculaire de l'une des faces (600) d'un substrat source (6), dite "face avant", sur la face en regard (700) dudit substrat support (7), dite "face de réception" et une étape de report sur ledit substrat support (7) d'une couche utile (66) provenant dudit substrat source (6), avant ladite étape de collage, seule l'une des deux faces entre ladite face avant (600) et ladite face de réception (700) subit une opération d'usinage destinée à former un épaulement (61, 71) sur au moins une partie de sa périphérie, cet épaulement (61, 71) délimitant une zone intérieure en saillie (72) qui possède une face supérieure (620, 720) dont le contour (C"₆, C" '₆, C"₇, C" '₇) est régulier, ce procédé étant **caractérisé en ce que** l'autre des deux faces (700, 600) étant bordée par un chanfrein primaire (79, 69) et présentant une zone centrale rigoureusement plane (77, 67), dite "zone plane" et une zone Intermédiaire (78, 68), dite de "chanfrein secondaire", située entre ledit chanfrein primaire (79, 69) et ladite zone plane (77, 67), les dimensions du contour (C"₆, C" '₆, C" ₇, C" '₇) de ladite face supérieure (620, 720) de la zone en saillie (62, 72) étant inférieures ou égales aux dimensions du contour extérieur (C'₇. C'₆) de la zone de chanfrein secondaire (78, 68) du substrat (7, 6) situé en regard, ladite face supérieure (620, 720) étant collée sur le substrat (7, 6) en regard, de façon que son contour (C"₆, C" '₆, C" ₇, C" '₇) soit inscrit à l'intérieur du contour extérieur (C'₇, C'₈) de ladite zone de chanfrein secondaire (78, 68), de sorte qu'après le collage, ladite couche utile (66) est reportée sur ledit substrat support (7), en présentant un contour (660) régulier.

2. Procédé selon la revendication 1, **caractérisé en ce que** les dimensions du contour (C" '₈, C" '₇) de ladite face supérieure (620, 720) de la zone en saillie (62, 72) du substrat (6, 7) ayant subi l'usinage sont inférieures ou égales aux dimensions du contour extérieur (C₇, C₆) de la zone plane (77, 67) du substrat (7, 6) situé en regard, ladite face supérieure (620, 720) étant collée sur le substrat (7, 6) situé en regard, de façon que son contour (C" '₆, C" '₇) soit inscrit à l'intérieur du contour extérieur (C₇, C₆) de ladite zone plane (77, 67).

3. Procédé selon la revendication 2 ou 3, **caractérisé en ce que** la face supérieure (620, 720) de la zone en saillie (62, 72) du substrat (6, 7) ayant subi l'usinage est collée sur le substrat (7, 6) situé en regard, de façon qu'elle soit centrée par rapport à la zone de chanfrein secondaire (78, 68) ou à la zone plane (77, 67) de celui-ci.

4. Procédé selon l'une des revendications précédentes, **caractérisé en ce que** l'étape d'usinage de l'épaulement (61) est effectuée sur la face avant (600) du substrat source (6),

5. Procédé selon l'une quelconque des revendications précédentes, **caractérisé en ce que** le chant latéral (63, 73) de la zone en saillie (62, 72) est sensiblement perpendiculaire au plan de la face supérieure (620, 720) de celle-ci.

6. Procédé selon l'une quelconque des revendications précédentes, **caractérisé en ce qu'**il consiste avant l'étape de collage, à former une zone de fragilisation (65) à l'intérieur dudit substrat source (6), ladite couche utile (66) s'étendant entre cette zone de fragilisation (65) et la face avant (600) dudit substrat (6) et après l'étape de collage, à effectuer le détachement de ladite couche utile (66) du reste du substrat source (6), le long de cette zone de fragilisation (65).

7. Procédé selon la revendication 6 lorsqu'elle est dépendante de la revendication 4, **caractérisé en ce que** l'opération d'usinage de l'épaulement (61) sur la face avant (600) du substrat source (6) est effectuée avant l'étape de formation de la zone de fragilisation (65).

8. Procédé selon la revendication 6 lorsqu'elle est dépendante de la revendication 4, **caractérisé en ce que** l'opération d'usinage de l'épaulement (61) sur la face avant (600) du substrat source (6) est effectuée après l'étape de formation de la zone de fragilisation (65).

9. Procédé selon la revendication 6 lorsqu'elle est dépendante de la revendication 4, **caractérisé en ce que** la hauteur (H₆) de la zone en saillie (62) du substrat source est supérieure ou égale à l'épaisseur (E) de ladite couche utile (66).

10. Procédé selon la revendication 6 lorsqu'elle est dépendante de la revendication 4, **caractérisé en ce que** la hauteur (H₆) de ladite zone en saillie (62) du substrat source (6) est très nettement supérieure à l'épaisseur (E) de ladite couche utile (66) et **en ce qu'**après l'étape de détachement de ladite couche utile (66) du reste du substrat source (6), on effectue au moins une fois le cycle suivant d'opérations, consistant à :
- a) former une zone de fragilisation (65) à l'intérieur de ladite zone en saillie (62), la couche utile (66) s'étendant entre cette zone de fragilisation (65) et la face supérieure (620) de la zone en saillie (62),
- b) coller par adhésion moléculaire cette face supérieure (620), sur la face de réception (700) du substrat support (7), de façon que son contour (C"₆, C"'₆) soit inscrit à l'intérieur du contour extérieur (C'₇) de la zone de chanfrein secondaire (78) dudit support (7),
- c) détacher ladite couche utile (66) du reste du substrat source (6), le long de cette zone de fragilisation (65).

11. Procédé selon la revendication 10, **caractérisé en ce que** préalablement à l'étape a), on effectue une étape de retouche de la face supérieure (620) de la zone en saillie (62).

12. Procédé selon l'une quelconque des revendications 6 à 11. **caractérisé en ce que** ladite zone de fragilisation (65) est formée par implantation d'espèces atomiques.

13. Procédé selon l'une quelconque des revendications 6 à 11, **caractérisé en ce que** ladite zone de fragilisation (65) est formée d'une couche poreuse.

14. Procédé selon l'une quelconque des revendications précédentes, **caractérisé en ce que** la hauteur (H₆, H₇) de ladite zone en saillie (62, 72) est supérieure ou égale à 10nm, de préférence supérieure à égale à 200 nm.

15. Procédé selon l'une quelconque des revendications 6 à 14, **caractérisé en ce que** le détachement de la couche utile (66) est effectué par au moins l'une des techniques suivantes prises seules ou en combinaison parmi l'application de contraintes d'origine mécanique ou électrique, l'apport d'énergie thermique et la gravure chimique.

16. Procédé selon l'une quelconque des revendications précédentes, **caractérisé en ce que** le substrat support (7) est réalisé dans un matériau semi-conducteur ou non, choisi parmi le silicium, un substrat transparent, le carbure de silicium, l'arséniure de gallium, le phosphure d'indium et le germanium.

17. Procédé selon l'une quelconque des revendications précédentes, **caractérisé en ce que** le substrat source (6) est réalisé dans un matériau semi-conducteur.

18. Procédé selon la revendication 17, **caractérisé en ce que** le matériau du substrat source (6) est choisi parmi le silicium, le germanium, les composés de silicium et de germanium, le carbure de silicium, le nitrure de gallium, l'arséniure de gallium et le phosphure d'indium.

19. Procédé selon l'une quelconque des revendications précédents, **caractérisé en ce qu'**au moins l'une des faces entre la face avant (600) du substrat source (6) et la face de réception (700) du substrat support (7) qui sont collées l'une contre l'autre est recouverte d'une couche d'un matériau isolant.
